# EUROPEAN PATENT APPLICATION

(11) **EP 4 708 920 A1**
(43) Date of publication of application: **11.03.2026**
(21) Application number: 23942111.8
(22) Date of filing: 31.10.2023
(51) Int. Cl.: H04R 19/04, H04R 31/00

(54) **MEMS MICROPHONE AND MANUFACTURING METHOD THEREFOR**

(30) Priority: 20.06.2023 CN 202310739195
(71) Applicant: China Resources Microelectronics Holdings Limited, Jingan District Shanghai 200072 (CN)
(72) Inventor: JIN, Wenchao, Shanghai 200072 (CN); LI, Shaoping, Shanghai 200072 (CN); YAN, Kai, Shanghai 200072 (CN); GAO, Duoduo, Shanghai 200072 (CN); HU, Yonggang, Shanghai 200072 (CN); ZHANG, Liping, Shanghai 200072 (CN); WANG, Jie, Shanghai 200072 (CN)
(74) Representative: HGF
(86) International application number: PCT/CN2023/128058
(87) International publication number: WO 2024/259844

(57) **Abstract**

A MEMS microphone and a manufacturing method therefor are provided. The MEMS microphone includes a first microphone structure (110), a second microphone structure (120) and a common vibrating diaphragm (130). The first microphone structure (110) includes a first vibrating diaphragm (111), a first backplate (112) and a second vibrating diaphragm (113) arranged at intervals from bottom to top. A first cavity (114) is formed between the first vibrating diaphragm (111) and the second vibrating diaphragm (113). The first backplate (112) is arranged parallel to the first vibrating diaphragm (111) and the second vibrating diaphragm (113) and extends through the first cavity (114). The second microphone structure (120) includes a third vibrating diaphragm (121), a second backplate (122) and a fourth vibrating diaphragm (123) arranged at intervals from top to bottom. A second cavity (124) is formed between the third vibrating diaphragm (121) and the fourth vibrating diaphragm (123). The second backplate (122) is arranged parallel to the third vibrating diaphragm (121) and the fourth vibrating diaphragm (123) and extends through the second cavity (124). The common vibrating diaphragm (130) is formed by directly bonding the second vibrating diaphragm (113) and the fourth vibrating diaphragm (123). In the MEMS microphone and the manufacturing method therefor, a microphone structure having three diaphragms and two backplates is formed by means of forming the common vibrating diaphragm (130), thus improving the performance of the MEMS microphone, and reducing the process difficulty of manufacturing the MEMS microphone.

## Description

The present application claims priority to Chinese Patent Application No. 202310739195.0, entitled "MEMS Microphone and Manufacturing Method therefor", and filed with the China Patent Office on June 20, 2023, the content of which is expressly incorporated herein by reference in its entirety.

### TECHNICAL FIELD

The present application relates to the field of semiconductor technology, particularly to a MEMS microphone and a manufacturing method therefor.

### BACKGROUND

Micro Electro Mechanical System (MEMS) technology is a high-tech field that has developed rapidly in recent years. MEMS employs advanced semiconductor manufacturing processes to enable mass production of sensors, actuators, and other devices. Compared to conventional counterparts, MEMS devices have significant advantages in terms of size, power consumption, weight, and cost. Major applications of MEMS devices on the market include pressure sensors, accelerometers, and silicon microphones.

A MEMS silicon microphone is an acoustic sensor that converts sound pressure into an analog signal, which consists of a MEMS sensor and an ASIC (Application Specific Integrated Circuit) chip. Existing technology allows these two components to be electrically connected via wire bonding and placed within a single package. The MEMS sensor is a variable capacitor with a fixed backplate and a vibrating diaphragm. When sound pressure is applied to the sensor, the diaphragm vibrates in response to sound, changing the distance between the backplate and the diaphragm, thereby altering the capacitance of the variable capacitor. The change in capacitance is determined by the sound wave parameters, and the capacitance is converted into an analog signal for further analysis and processing in the ASIC.

To further improve the performance of MEMS silicon microphones, two main approaches are currently employed. The first one is to increase the size of the device to enhance sensitivity and SNR (Signal-to-Noise Ratio), which, however, contradicts the miniaturization trend and is not conducive to device integration. The second one is to design new structures for silicon microphones to realize differential signal output, which reduces noise and achieves high SNR performance. However, these new structures involve complex fabrication processes and high manufacturing difficulty, making large-scale production and cost reduction challenging.

### SUMMARY

In the summary, a series of concepts in the simplified form are introduced, which will be further described in detail through the embodiments. The invention content of the present application does not mean an attempt to limit the key features and essential technical features of the technical solution claimed for protection, nor does it mean an attempt to determine the scope of protection of the technical solution claimed for protection.

The present application provides a MEMS microphone, including a first microphone structure, a second microphone structure, and a common vibrating diaphragm;
the first microphone structure includes a first vibrating diaphragm, a first backplate, and a second vibrating diaphragm arranged at intervals from bottom to top, a first cavity is formed between the first vibrating diaphragm and the second vibrating diaphragm, and the first backplate is arranged parallel to the first vibrating diaphragm and the second vibrating diaphragm and extends through the first cavity;
the second microphone structure includes a third vibrating diaphragm, a second backplate, and a fourth vibrating diaphragm arranged at intervals from top to bottom, a second cavity is formed between the third vibrating diaphragm and the fourth vibrating diaphragm, and the second backplate is arranged parallel to the third vibrating diaphragm and the fourth vibrating diaphragm and extends through the second cavity; and
the common vibrating diaphragm is formed by bonding the second vibrating diaphragm and the fourth vibrating diaphragm.

In an embodiment, the first vibrating diaphragm, the first backplate, the common vibrating diaphragm, the second backplate, and the third vibrating diaphragm serve as a first electrode, a second electrode, a third electrode, a fourth electrode, and a fifth electrode of the MEMS microphone, respectively.

In an embodiment, a plurality of first pillars are further provided in the first cavity, both ends of each of the plurality of first pillars are connected to the first vibrating diaphragm and the second vibrating diaphragm respectively, a plurality of second pillars are further provided in the second cavity, and both ends of each of the plurality of second pillars are connected to the third vibrating diaphragm and the fourth vibrating diaphragm respectively.

In an embodiment, the plurality of first pillars are arranged perpendicular to the first vibrating diaphragm and the second vibrating diaphragm and extend through the first cavity, and the plurality of second pillars are arranged perpendicular to the third vibrating diaphragm and the fourth vibrating diaphragm and extend through the second cavity.

In an embodiment, a plurality of first sound holes are formed in the first backplate, the plurality of first pillars extend through the plurality of first sound holes respectively, a plurality of second sound holes are formed in the second backplate, and the plurality of second pillars extend through the plurality of second sound holes respectively.

In an embodiment, a first support portion is further formed between the first vibrating diaphragm and the first backplate, a second support portion is further formed between the second vibrating diaphragm and the first backplate, the first vibrating diaphragm, the second vibrating diaphragm, the first support portion, the second support portion enclose to form the first cavity, a third support portion is further formed between the third vibrating diaphragm and the second backplate, a fourth support portion is further formed between the fourth vibrating diaphragm and the second backplate, and the third vibrating diaphragm, the fourth vibrating diaphragm, the third support portion, and the fourth support portion enclose to form the second cavity.

In an embodiment, the first microphone structure is formed on a first substrate, and a first isolation layer is formed between the first substrate and the first vibrating diaphragm.

The present application further provides a MEMS microphone and a method for manufacturing the MEMS microphone, including:
providing a first microphone structure and a second microphone structure, wherein the first microphone structure includes a first vibrating diaphragm, a first backplate, and a second vibrating diaphragm arranged at intervals from bottom to top, a first cavity is formed between the first vibrating diaphragm and the second vibrating diaphragm, the first backplate is arranged parallel to the first vibrating diaphragm and the second vibrating diaphragm and extends through the first cavity, the second microphone structure includes a third vibrating diaphragm, a second backplate, and a fourth vibrating diaphragm arranged at intervals from top to bottom, a second cavity is formed between the third vibrating diaphragm and the fourth vibrating diaphragm, and the second backplate is arranged parallel to the third vibrating diaphragm and the fourth vibrating diaphragm and extends through the second cavity; and
bonding the second vibrating diaphragm and the fourth vibrating diaphragm directly to form a common vibrating diaphragm.

In an embodiment, providing the first microphone structure and the second microphone structure includes:
manufacturing and forming one or more first microphone structures on a first substrate; and
manufacturing and forming one or more second microphone structures on a second substrate.

In an embodiment, manufacturing and forming one or more first microphone structures on the first substrate includes:
forming the first vibrating diaphragm on the first substrate;
forming a first support layer on the first vibrating diaphragm;
forming a first backplate layer on the first support layer, patterning the first backplate layer to form the first backplate, wherein a plurality of first sound holes are formed in the first backplate;
forming a second support layer on the first backplate;
etching the first support layer and the second support layer to form a plurality of first through holes extending through the first support layer and the second support layer, wherein the plurality of first through holes extend through the plurality of first sound holes respectively;
filling the plurality of first through holes to form a plurality of first pillars;
forming a second vibrating diaphragm layer on the second support layer, patterning the second vibrating diaphragm layer to form the second vibrating diaphragm, wherein a plurality of diaphragm holes are formed in the second vibrating diaphragm; and
etching the first support layer and the second support layer to form the first cavity between the first vibrating diaphragm and the second vibrating diaphragm, wherein a remaining portion of the first support layer forms a first support portion, and a remaining portion of the second support layer forms a second support portion.

In an embodiment, manufacturing and forming one or more second microphone structures on the second substrate includes:
forming the third vibrating diaphragm on the second substrate;
forming a third support layer on the third vibrating diaphragm;
forming a second backplate layer on the third support layer, and patterning the second backplate layer to form the second backplate, wherein a plurality of second sound holes are formed in the second backplate;
forming a fourth support layer on the second backplate;
etching the third support layer and the fourth support layer to form a plurality of second through holes extending through the third support layer and the fourth support layer, wherein the plurality of second through holes extend through the plurality of second sound holes respectively;
filling the plurality of second through holes to form a plurality of second pillars;
forming a fourth vibrating diaphragm layer on the fourth support layer, and patterning the fourth vibrating diaphragm layer to form the fourth vibrating diaphragm, wherein a plurality of diaphragm holes are formed in the fourth vibrating diaphragm; and
etching the third support layer and the fourth support layer to form the second cavity between the third vibrating diaphragm and the fourth vibrating diaphragm, wherein a remaining portion of the third support layer forms a third support portion, and a remaining portion of the fourth support layer forms a fourth support portion.

In an embodiment, after directly bonding the second vibrating diaphragm and the fourth vibrating diaphragm to form the common vibrating diaphragm further, the method further includes:
removing the second substrate to expose the third vibrating diaphragm; and
etching the first substrate to expose a region on the first vibrating diaphragm corresponding to the first cavity.

According to the MEMS microphone and the manufacturing method thereof provided in the present application, the first microphone structure and the second microphone structure with dual diaphragms and a single backplate are first manufactured, and then the diaphragm of the first microphone structure is directly bonded with the diaphragm of the second microphone structure to form the common vibrating diaphragm to form a microphone structure with three diaphragms and dual backplates, thereby improving the performance of the MEMS microphone and reducing the process difficulty of manufacturing the MEMS microphone.

### BRIEF DESCRIPTION OF THE DRAWINGS

The following accompanying drawings of the present application are incorporated herein as part of the present application and are useful for understanding the present application. The embodiments of the present application and the description thereof are shown in the drawings to explain the principle of the present application.

In the drawings:
FIG. 1 is a schematic structure diagram of a MEMS microphone according to embodiments of the present application.
FIG. 2 shows a flow chart of a method for manufacturing a MEMS microphone according to embodiments of the present application.
FIG. 3 shows a flow chart of a method for manufacturing a first microphone structure according to embodiments of the present application.
FIGS. 4A to 4E are schematic cross-sectional views of structures sequentially obtained by performing a method for manufacturing a first microphone structure according to embodiments of the present application.
FIG. 5 is a schematic cross-sectional view of a structure obtained by bonding a first microphone structure and a second microphone structure according to embodiments of the present application.

### DETAILED DESCRIPTION

In the following description, numerous specific details are provided to offer a more thorough understanding of the present application. However, it is apparent to those skilled in the art that the present application can be implemented without one or more of these details. In other examples, in order to avoid confusion with the present application, certain well-known technical features in the field have not been described.

It should be understood that the present application can be implemented in various forms and should not be construed as limited to the embodiments presented herein. On the contrary, the provision of these embodiments serves to make the disclosure thorough and complete, and to fully convey the scope of the present application to those skilled in the art. In the accompanying drawings, for the sake of clarity, the dimensions and relative sizes of layers and regions may be exaggerated. Like reference numerals throughout denote like elements.

It should be appreciated that when an element or a layer is referred to as being "on", "adjacent to", "connected to" or "coupled to" other elements or layers, the element or layer may be directly located on, adjacent to, connected to, or coupled to other elements or layers, or there may exist an intermediate element or layer. Rather, when an element is referred to as being "directly on", "adjacent to", "directly connected to" or "directly coupled to" other elements or layers, there is no intermediate element or layer. It should be appreciated that, although the terms first, second, third, and the like may be used for describing various elements, components, regions, layers, and/or portions, these elements, components, regions, layers, and/or portions shall not be limited by these terms. These terms are utilized only to distinguish one element, component, region, layer, or portion from another element, component, region, layer, or portion. Therefore, without departing from the teaching of the present application, the first element, component, region, layer, or portion discussed below may be represented as a second element, component, region, layer, or portion.

The spatial relationship terms such as "below", "under", "lower", "beneath" "above", "upper" and the like may be used herein for convenience of description, in order to describe a relationship between one element or feature and other elements or features shown in the figures. It should be appreciated that, in addition to the orientations shown in the figures, the intention of the spatial relationship terms further includes different orientations of a component in use and operations. For example, if the component in the drawing is turned over, an element or feature described as "under", "below" or "beneath" other elements or features will be oriented to be "above" other elements or features. Therefore, the exemplary terms "under" or "below" may include two orientations: upper and lower. The device may be otherwise oriented (rotated by 90 degrees or other orientations) and the spatial relationship terms used herein are interpreted accordingly.

The terms used herein are merely intended to describe specific embodiments and are not intended to limit the present application. In use herein, the singular forms "a", "an" and "the/said" are also intended to include plural forms unless the context clearly indicates another manner. It should also be appreciated that the terms "comprising" and/or "including" mean to determine the presence of the features, integers, steps, operations, elements, and/or components when used in the description, but do not exclude the presence or addition of one or more other features, integers, steps, operations, elements, components and/or groups. In use herein, the term "and/or" includes any and all combinations of the listed relevant items.

In order to fully understand the present application, detailed steps, and detailed structures are proposed in the following description, to explain the technical solution provided in the present application. Some embodiments of the present application are elaborated as follows. However, in addition to these detailed descriptions, the present application may have other implementation modes.

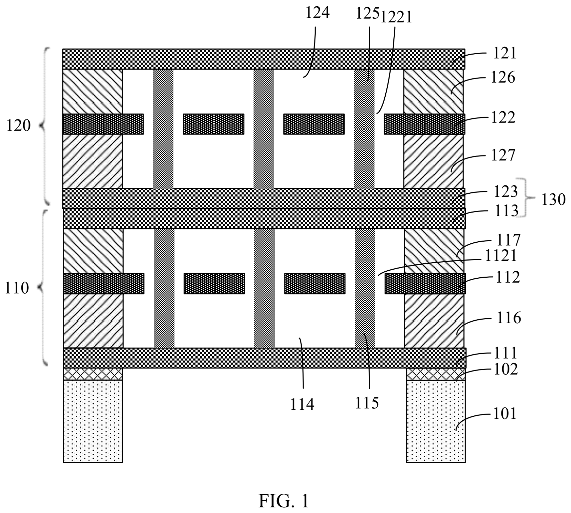

In view of the above problem, the present application provides a MEMS microphone, as shown in FIG. 1, which includes a first microphone structure 110, a second microphone structure 120, and a common vibrating diaphragm 130.

The first microphone structure 110 includes a first vibrating diaphragm 111, a first backplate 112, and a second vibrating diaphragm 113 arranged at intervals from bottom to top. A first cavity 114 is formed between the first vibrating diaphragm 111 and the second vibrating diaphragm 113. The first backplate 112 is arranged parallel to the first vibrating diaphragm 111 and the second vibrating diaphragm 113, and extends through the first cavity 114.

The second microphone structure 120 includes a third vibrating diaphragm 121, a second backplate 122, and a fourth vibrating diaphragm 123 arranged at intervals from top to bottom. A second cavity 124 is formed between the third vibrating diaphragm 121 and the fourth vibrating diaphragm 123. The second backplate 122 is arranged parallel to the third vibrating diaphragm 121 and the fourth vibrating diaphragm 123, and extends through the second cavity 124.

The common vibrating diaphragm 130 is formed by bonding the second vibrating diaphragm 113 and the fourth vibrating diaphragm 123.

As an example, a plurality of first pillars 115 are further provided in the first cavity 114, and both ends of each of the plurality of first pillars 115 are respectively connected to the first vibrating diaphragm 111 and the second vibrating diaphragm 113. In an embodiment, the plurality of first pillars 115 are arranged perpendicular to the first vibrating diaphragm 111 and the second vibrating diaphragm 113, and extend through the first cavity 114.

As an example, a plurality of second pillars 125 are further provided in the second cavity 124, and both ends of each of the plurality of second pillars 125 are respectively connected to the third vibrating diaphragm 121 and the fourth vibrating diaphragm 123. In an embodiment, the plurality of second pillars 125 are arranged perpendicular to the third vibrating diaphragm 121 and the fourth vibrating diaphragm 123, and extend through the second cavity 124.

In an embodiment, a plurality of first sound holes 1121 are formed in the first backplate 112. The plurality of first pillars 115 extend through the plurality of first sound holes 1121 respectively, and the plurality of first pillars 115 are not in contact with the first backplate 112. A plurality of second sound holes 1221 are formed in the second backplate 122. The plurality of second pillars 125 extend through the plurality of second sound holes 1221 respectively, and the plurality of second pillars 125 are not in contact with the second backplate 122.

In an embodiment, a first support portion 116 is further formed between the first vibrating diaphragm 111 and the first backplate 112, and a second support portion 117 is further formed between the second vibrating diaphragm 113 and the first backplate 112. The first vibrating diaphragm 111, the second vibrating diaphragm 113, the first support portion 116, and the second support portion 117 enclose to form the first cavity 114.

In an embodiment, a third support portion 126 is further formed between the third vibrating diaphragm 121 and the second backplate 122, and a fourth support portion 127 is further formed between the fourth vibrating diaphragm 123 and the second backplate 122. The third vibrating diaphragm 121, the fourth vibrating diaphragm 123, the third support portion 126, and the fourth support portion 127 enclose to form the second cavity 124.

In an embodiment, the first microphone structure 110 is formed on the first substrate 101, and a first isolation layer 102 is formed between the first substrate 101 and the first vibrating diaphragm. The first substrate 101 and the first isolation layer 102 are only provided in a region corresponding to the first support portion 116 and the second support portion 117, while a region corresponding to the first cavity 114 is not provided with the first substrate 101 and the first isolation layer 102.

In an embodiment, pressures in the first cavity 114 and the second cavity 124 can be set as needed, for example, to a low-pressure state or a vacuum state.

As an example, the first vibrating diaphragm 111, the first backplate 112, the common vibrating diaphragm 130, the second backplate 122, and the third vibrating diaphragm 121 serve as a first electrode P1, a second electrode P2, a third electrode P3, a fourth electrode P4, and a fifth electrode P5 of the MEMS microphone, respectively. When P1, P3, and P5 are electrically connected to each other, and P2 is electrically connected to P4, a single-ended ultra-large capacitance output can be realized, a capacitor area is increased, and the sensitivity can be effectively improved. The P1, P2, and P3 can output differential capacitive signals, and the P3, P4, and P5 can also generate differential capacitive signals. Two differential capacitive signals are then superimposed, which can effectively improve the signal-to-noise ratio.

In the present application, the common vibrating diaphragm 130 is formed by directly bonding the second vibrating diaphragm 113 and the fourth vibrating diaphragm 123. The first microphone structure 110 and the second microphone structure 120 each having dual diaphragms and a single backplate are face-to-face bonded together in a cavity-to-cavity bonding manner to form a three-diaphragm/dual-backplate capacitive MEMS microphone structure with high sensitivity, small volume, high SNR, and excellent performance.

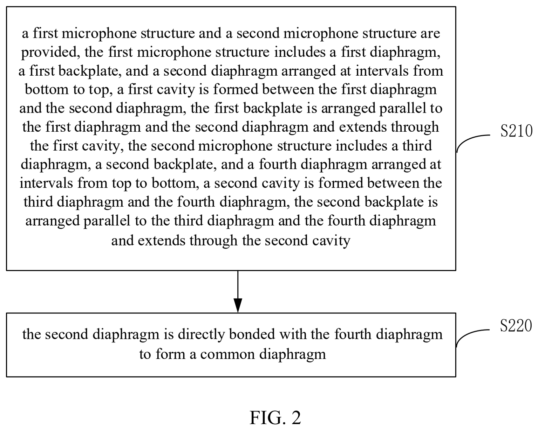

The present application further provides a method for manufacturing a MEMS microphone, as shown in FIG. 2, the method includes the following steps.

In step S210, a first microphone structure and a second microphone structure are provided. The first microphone structure includes a first vibrating diaphragm, a first backplate, and a second vibrating diaphragm arranged at intervals from bottom to top. A first cavity is formed between the first vibrating diaphragm and the second vibrating diaphragm. The first backplate is arranged parallel to the first vibrating diaphragm and the second vibrating diaphragm and extends through the first cavity. The second microphone structure includes a third vibrating diaphragm, a second backplate, and a fourth vibrating diaphragm arranged at intervals from top to bottom. A second cavity is formed between the third vibrating diaphragm and the fourth vibrating diaphragm. The second backplate is arranged parallel to the third vibrating diaphragm and the fourth vibrating diaphragm and extends through the second cavity.

In step S220, the second vibrating diaphragm is directly bonded with the fourth vibrating diaphragm to form a common vibrating diaphragm.

As an example, the first microphone structure in step S210 is formed on the first substrate, and one or more first microphone structures may be manufactured on the first substrate simultaneously.

As an example, the first substrate may be any appropriate semiconductor substrate such as a silicon substrate. The first substrate may also be made of at least one of the following materials: Si, Ge, SiGe, SiC, SiGeC, InAs, GaAs, InP or other III/V compound semiconductors, and may also include a multilayer structure consisting of these semiconductor materials. The first substrate may include Silicon on Insulator (SOI), Stacked Silicon on Insulator (SSOI), Stacked Silicon-Germanium on Insulator (S-SiGeOI), Silicon-Germanium on Insulator (SiGeOI), or Germanium on Insulator (GeOI), or may be a Double Side Polished Wafer (DSP), or may be a ceramic substrate such as alumina, a quartz substrate or a glass substrate, etc. In an embodiment, the first substrate is made of single-crystal silicon with a crystal orientation of <100>.

As an example, a distance between the first vibrating diaphragm and the second vibrating diaphragm may be equal or unequal to a distance between the third vibrating diaphragm and the fourth vibrating diaphragm.

In an embodiment, a first isolation layer is further formed on the first substrate. In an embodiment, the first isolation layer may be formed by using a physical vapor deposition process or a chemical vapor deposition process, etc. The first isolation layer includes but is not limited to, a silicon oxide layer. The thickness of the first isolation layer is in a range of 0.5 µm to 2 µm.

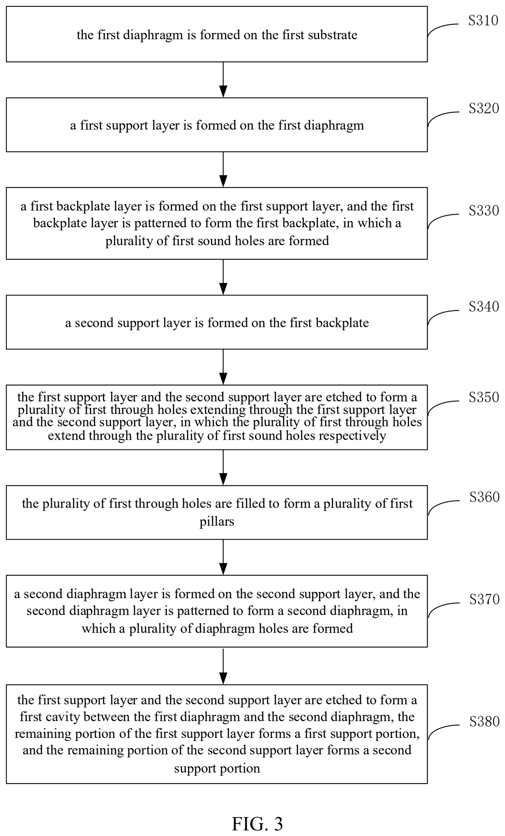

With reference to FIG. 3, the step of manufacturing one or more first microphone structures on the first substrate includes the following steps.

In step S310, a first vibrating diaphragm is formed on the first substrate.

In step S320, a first support layer is formed on the first vibrating diaphragm.

In step S330, a first backplate layer is formed on the first support layer, and the first backplate layer is patterned to form the first backplate, in which a plurality of first sound holes are formed.

In step S340, a second support layer is formed on the first backplate.

In step S350, the first support layer and the second support layer are etched to form a plurality of first through holes extending through the first support layer and the second support layer, and the plurality of first through holes extend through the plurality of first sound holes respectively.

In step S360, the plurality of first through holes are filled to form a plurality of first pillars.

In step S370, a second vibrating diaphragm layer is formed on the second support layer, and the second vibrating diaphragm layer is patterned to form a second vibrating diaphragm, in which a plurality of diaphragm holes are formed.

In step S380, the first support layer and the second support layer are etched to form a first cavity between the first vibrating diaphragm and the second vibrating diaphragm, the remaining portion of the first support layer forms a first support portion, and the remaining portion of the second support layer forms a second support portion.

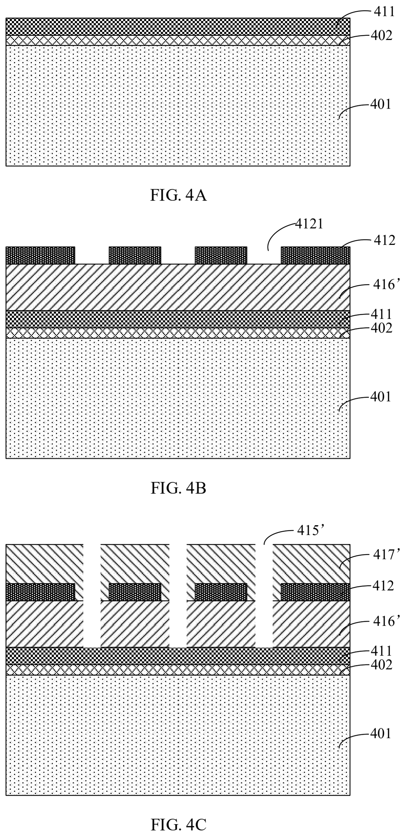

The method for manufacturing the first microphone structure of the present application will be elaborated below with reference to FIGS. 4A to 4E which are schematic cross-sectional views of structures sequentially obtained by performing the method for manufacturing the first microphone structure according to the embodiments of the present application.

Firstly, step S310 is performed. As shown in FIG. 4A, a first vibrating diaphragm 411 is formed on a first substrate 401.

In an embodiment, a layer of diaphragm material is deposited on a surface of a first isolation layer 402 through a conventional semiconductor process to form a first vibrating diaphragm 411 which covers the first isolation layer 402. The material of the first vibrating diaphragm 411 includes but is not limited to doped polysilicon. The thickness of the first vibrating diaphragm 411 is in a range of 0.2 µm to 1 µm.

In an embodiment, the conventional semiconductor process for forming the first isolation layer 402 can be selected as needed, such as one of low-pressure chemical vapor deposition (LPCVD) formed by a chemical vapor deposition (CVD) method, a physical vapor deposition (PVD) method or an atomic layer deposition (ALD) method, laser ablation deposition (LAD), or selective epitaxial growth (SEG), or one of low-temperature chemical vapor deposition (LTCVD), rapid thermal chemical vapor deposition (RTCVD), or plasma enhanced chemical vapor deposition (PECVD). The LPCVD method is preferred here.

Subsequently, step S320 is performed. As shown in FIG. 4B, a first support layer 416' is formed on the first vibrating diaphragm 411.

In an embodiment, the first support layer 416' is formed on the first vibrating diaphragm 411 through a conventional semiconductor process such as the LPCVD or PECVD method, and the first support layer 416' covers the first vibrating diaphragm 411. The material of the first support layer 416' includes, but is not limited to, silicon dioxide. The thickness of the first support layer 416' is in a range of 1 µm to 3 µm.

Subsequently, step S330 is performed. As shown in FIG. 4B, a first backplate layer is formed on the first support layer 416', and the first backplate layer is patterned to form a first backplate 412, in which a plurality of first sound holes 4121 are formed.

In an embodiment, the first backplate layer is formed on the surface of the first support layer 416' through a conventional semiconductor process such as the LPCVD or PECVD method. The material of the first backplate layer includes but is not limited to doped polysilicon. In an embodiment, the first backplate layer may be a single-layer doped polysilicon layer or a combination of a doped polysilicon layer and a passivation layer. The material of the passivation layer includes but is not limited to silicon nitride, silicon carbide, silicon oxynitride, etc. The first backplate layer may be patterned by a photolithography process to form the first backplate 412, which will not repeated herein. The thickness of the first backplate 412 is in a range of 0.5 µm to 2 µm.

Subsequently, step S340 is performed. As shown in FIG. 4C, a second support layer 417' is formed on the first backplate 412.

In an embodiment, a second support layer 417' is formed on the first backplate 412 through a conventional semiconductor process such as the LPCVD or PECVD method, and the second support layer 417' covers the first backplate 412. The material of the second support layer 417' includes, but is not limited to, silicon dioxide. The thickness of the second support layer 417' is in a range of 1 µm to 3 µm.

Subsequently, step S350 is performed. As shown in FIG. 4C, the first support layer 416' and the second support layer 417' are etched to form a plurality of first through holes 415' extending through the first support layer 416' and the second support layer 417', and the plurality of first through holes 415' extend through the plurality of first sound holes 4121 respectively.

In an embodiment, the first support layer 416' and the second support layer 417' may be patterned through a photolithography process to form the plurality of first through holes 415' extending through the first support layer 416' and the second support layer 417' until the first vibrating diaphragm 411 is exposed. It should be noted that the plurality of first through holes 415' extend through the plurality of first sound holes 4121 in the first backplate 412 respectively, so that the plurality of first through holes 415' have no contact with the first backplate 412.

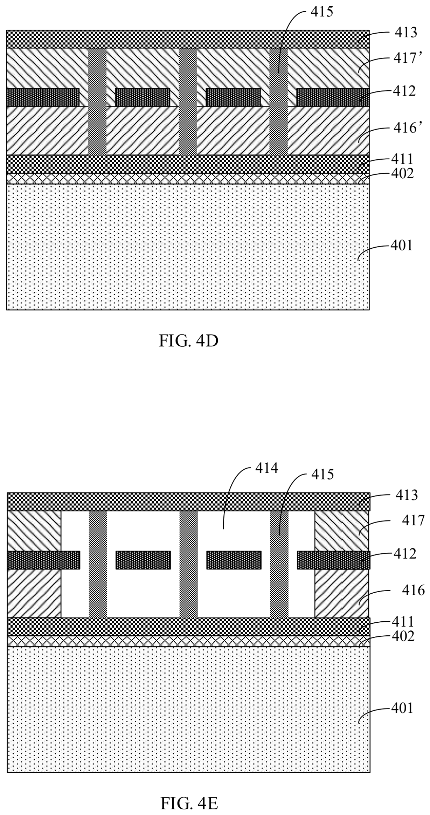

Subsequently, step S360 is performed. As shown in FIG. 4D, the plurality of first through holes 415' are filled to form a plurality of first pillars 415.

In an embodiment, a layer of material is deposited through a conventional semiconductor process such as the LPCVD method, and the plurality of first through holes 415' are completely filled. The surface material is then removed through the CMP process. The second support layer 417' serves as a stop layer. The remaining material is filled in the plurality of first through holes 415' to form the plurality of first pillars 415. The first pillar 415 may be made of a conductive material or a non-conductive material. The diameter of the first pillar 415 is in a range of 0.5 µm to 3 µm.

Subsequently, step S370 is performed. As shown in FIG. 4D, a second vibrating diaphragm layer is formed on the second support layer 417', and the second vibrating diaphragm layer is patterned to form the second vibrating diaphragm 413, in which a plurality of diaphragm holes (not shown) are formed.

In an embodiment, a layer of diaphragm material (i.e., the second vibrating diaphragm layer) is deposited on the second support layer 417' and the first pillars 415 through a conventional semiconductor process such as the LPCVD method, and then the diaphragm material is patterned through the photolithography process to form the second vibrating diaphragm 413 having the plurality of diaphragm holes. The material of the second vibrating diaphragm 413 includes but is not limited to doped polysilicon. The thickness of the second vibrating diaphragm 413 is in a range of 0.2 µm to 0.5 µm.

In an embodiment, the second vibrating diaphragm layer is patterned through the photolithography process. In an embodiment, a photoresist layer with a diaphragm hole pattern can be formed by spin-coating a photoresist, followed by processes such as exposure, development, and cleaning. Subsequently, the second vibrating diaphragm layer is etched with the photoresist layer having the diaphragm hole pattern as a mask, thereby forming the second vibrating diaphragm 413 having a plurality of diaphragm holes.

It should be noted that after the second vibrating diaphragm 413 is formed, the method may further include that depositing a layer of oxide film on the surface of the second vibrating diaphragm 413 through conventional semiconductor processes such as LPCVD or PECVD method, and grounding it to the second vibrating diaphragm 413 through the CMP process to obtain a bonding surface with roughness meeting requirements.

Subsequently, step S380 is performed. As shown in FIG. 4E, the first support layer 416' and the second support layer 417' are etched to form the first cavity 414 between the first vibrating diaphragm 411 and the second vibrating diaphragm 413. The remaining portion of the first support layer forms the first support portion 416, and the remaining portion of the second support layer forms the second support portion 417.

In an embodiment, the first cavity 414 is formed by the wet etching. Specifically, the support layer is etched away by solutions such as HF, BOE or Vapor HF to obtain the structure as shown in FIG. 4E.

As an example, the second microphone structure in step S210 is formed on the second substrate. Further, one or more second microphone structures may be manufactured on the second substrate simultaneously.

As an example, the step of manufacturing one or more second microphone structures on the second substrate may include that a third vibrating diaphragm is formed on the second substrate, a third support layer is formed on the third vibrating diaphragm, a second backplate layer is formed on the third support layer and is patterned to form a second backplate in which a plurality of second sound holes are formed, a fourth support layer is formed on the second backplate, the third support layer and the fourth support layer are etched to form a plurality of second through holes extending through the third support layer and the fourth support layer and extending through the plurality of second sound holes respectively, the plurality of second through holes are filled to form a plurality of second pillars, a fourth vibrating diaphragm layer is formed on the fourth support layer and is patterned to form a fourth vibrating diaphragm in which a plurality of diaphragm holes are formed, the third support layer and the fourth support layer are etched to form the second cavity between the third vibrating diaphragm and the fourth vibrating diaphragm, the remaining portion of the third support layer forms the third support portion, and the remaining portion of the fourth support layer forms the fourth support portion.

For the specific procedures, reference can be made to the step of manufacturing one or more first microphone structures on the first substrate, which will not be repeated here.

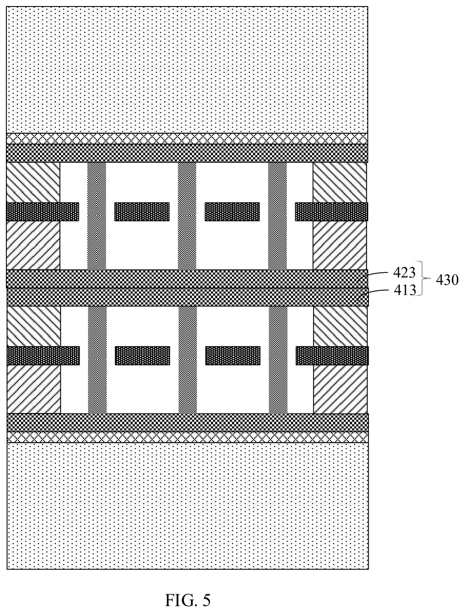

Subsequently, step S220 is performed, in which the second vibrating diaphragm 413 of the first microphone structure and the fourth vibrating diaphragm 423 of the second microphone structure obtained through the above step are directly bonded to form a common vibrating diaphragm 430, as shown in FIG. 5.

In an embodiment, pressures in the first cavity 414 and the second cavity can be set as needed, for example, to a low-pressure state or a vacuum state.

After step S220, the method may further include the steps of removing the second substrate and the second isolation layer through the CMP method or the like until the third vibrating diaphragm 421 is exposed, thinning the first substrate through the CMP method or the like, and then performing TSV process to create pad leads, and etching the first substrate and the first isolation layer through a backside etching process to expose a region on the first vibrating diaphragm corresponding to the first cavity, thereby forming the MEMS microphone device structure as shown in FIG. 1.

As an example, the first vibrating diaphragm 111, the first backplate 112, the common vibrating diaphragm 130, the second backplate 122, and the third vibrating diaphragm 121 serve as a first electrode P1, a second electrode P2, a third electrode P3, a fourth electrode P4, and a fifth electrode P5 of the MEMS microphone, respectively. When P1, P3, and P5 are electrically connected to each other, and P2 is electrically connected to P4, a single-ended ultra-large capacitance output can be realized, a capacitor area is increased, and the sensitivity can be effectively improved. The P1, P2, and P3 can output differential capacitive signals, and the P3, P4, and P5 can also generate differential capacitive signals. Two differential capacitive signals are then superimposed, which can effectively improve the signal-to-noise ratio.

Accordingly, key steps of the method for manufacturing a semiconductor device in the present application are introduced. For complete device manufacturing, other multiple process steps may be required, which will not be described one by one here.

It is worth mentioning that the order of the above steps is only an example. Under the premise of no contradiction, the above steps can also be reordered or performed alternately, etc.

According to the MEMS microphone and the manufacturing method thereof provided in the present application, the first microphone structure and the second microphone structure with dual diaphragms and a single backplate are first manufactured, and then the diaphragm of the first microphone structure is directly bonded with the diaphragm of the second microphone structure to form the common vibrating diaphragm to form a microphone structure with three diaphragms and dual backplates, thereby improving the performance of the MEMS microphone and reducing the process difficulty of manufacturing the MEMS microphone.

The present application is described through the above embodiments, but it should be appreciated that the above embodiments are only used for example and illustration, and are not intended to limit the present application to the scope of the described embodiments. In addition, those skilled in the art can understand that the present application is not limited to the above embodiments, and more variations and modifications can be made according to the teaching of the present application, and these variations and modifications all fall within the scope of protection of the present application. The protection scope of the present application should be subject to the appended claims and equivalents thereof.

## Claims

1. A MEMS microphone, comprising a first microphone structure, a second microphone structure, and a common vibrating diaphragm, wherein
the first microphone structure comprises a first vibrating diaphragm, a first backplate, and a second vibrating diaphragm arranged at intervals from bottom to top, a first cavity is formed between the first vibrating diaphragm and the second vibrating diaphragm, and the first backplate is arranged parallel to the first vibrating diaphragm and the second vibrating diaphragm and extends through the first cavity;
the second microphone structure comprises a third vibrating diaphragm, a second backplate, and a fourth vibrating diaphragm arranged at intervals from top to bottom, a second cavity is formed between the third vibrating diaphragm and the fourth vibrating diaphragm, and the second backplate is arranged parallel to the third vibrating diaphragm and the fourth vibrating diaphragm and extends through the second cavity; and
the common vibrating diaphragm is formed by bonding the second vibrating diaphragm and the fourth vibrating diaphragm.

2. The MEMS microphone according to claim 1, wherein the first vibrating diaphragm, the first backplate, the common vibrating diaphragm, the second backplate, and the third vibrating diaphragm serve as a first electrode, a second electrode, a third electrode, a fourth electrode, and a fifth electrode of the MEMS microphone, respectively.

3. The MEMS microphone according to claim 1, wherein a plurality of first pillars is further provided in the first cavity, both ends of each of the plurality of first pillars are connected to the first vibrating diaphragm and the second vibrating diaphragm respectively, a plurality of second pillars are further provided in the second cavity, and both ends of each of the plurality of second pillars are connected to the third vibrating diaphragm and the fourth vibrating diaphragm respectively.

4. The MEMS microphone according to claim 3, wherein the plurality of first pillars are arranged perpendicular to the first vibrating diaphragm and the second vibrating diaphragm and extend through the first cavity, and the plurality of second pillars are arranged perpendicular to the third vibrating diaphragm and the fourth vibrating diaphragm and extend through the second cavity.

5. The MEMS microphone according to claim 3, wherein a plurality of first sound holes are formed in the first backplate, the plurality of first pillars extend through the plurality of first sound holes respectively, a plurality of second sound holes are formed in the second backplate, and the plurality of second pillars extend through the plurality of second sound holes respectively.

6. The MEMS microphone according to claim 1, wherein a first support portion is further formed between the first vibrating diaphragm and the first backplate, a second support portion is further formed between the second vibrating diaphragm and the first backplate, the first vibrating diaphragm, the second vibrating diaphragm, the first support portion and the second support portion enclose to form the first cavity, a third support portion is further formed between the third vibrating diaphragm and the second backplate, a fourth support portion is further formed between the fourth vibrating diaphragm and the second backplate, and the third vibrating diaphragm, the fourth vibrating diaphragm, the third support portion and the fourth support portion enclose to form the second cavity.

7. The MEMS microphone according to claim 1, wherein the first microphone structure is formed on a first substrate, and a first isolation layer is formed between the first substrate and the first vibrating diaphragm.

8. A method for manufacturing a MEMS microphone, comprising:
providing a first microphone structure and a second microphone structure, wherein the first microphone structure comprises a first vibrating diaphragm, a first backplate, and a second vibrating diaphragm arranged at intervals from bottom to top, a first cavity is formed between the first vibrating diaphragm and the second vibrating diaphragm, the first backplate is arranged parallel to the first vibrating diaphragm and the second vibrating diaphragm and extends through the first cavity, the second microphone structure comprises a third vibrating diaphragm, a second backplate, and a fourth vibrating diaphragm arranged at intervals from top to bottom, a second cavity is formed between the third vibrating diaphragm and the fourth vibrating diaphragm, and the second backplate is arranged parallel to the third vibrating diaphragm and the fourth vibrating diaphragm and extends through the second cavity; and
bonding the second vibrating diaphragm and the fourth vibrating diaphragm directly to form a common vibrating diaphragm.

9. The method according to claim 8, wherein providing the first microphone structure and the second microphone structure comprises:
manufacturing and forming one or more first microphone structures on a first substrate; and
manufacturing and forming one or more second microphone structures on a second substrate.

10. The method according to claim 9, wherein manufacturing and forming one or more first microphone structures on the first substrate comprises:
forming the first vibrating diaphragm on the first substrate;
forming a first support layer on the first vibrating diaphragm;
forming a first backplate layer on the first support layer, patterning the first backplate layer to form the first backplate, wherein a plurality of first sound holes are formed in the first backplate;
forming a second support layer on the first backplate;
etching the first support layer and the second support layer to form a plurality of first through holes extending through the first support layer and the second support layer, wherein the plurality of first through holes extend through the plurality of first sound holes respectively;
filling the plurality of first through holes to form a plurality of first pillars;
forming a second vibrating diaphragm layer on the second support layer, patterning the second vibrating diaphragm layer to form the second vibrating diaphragm, wherein a plurality of diaphragm holes are formed in the second vibrating diaphragm; and
etching the first support layer and the second support layer to form the first cavity between the first vibrating diaphragm and the second vibrating diaphragm, wherein a remaining portion of the first support layer forms a first support portion, and a remaining portion of the second support layer forms a second support portion.

11. The method according to claim 9, wherein manufacturing and forming one or more second microphone structures on the second substrate comprises:
forming the third vibrating diaphragm on the second substrate;
forming a third support layer on the third vibrating diaphragm;
forming a second backplate layer on the third support layer, and patterning the second backplate layer to form the second backplate, wherein a plurality of second sound holes are formed in the second backplate;
forming a fourth support layer on the second backplate;
etching the third support layer and the fourth support layer to form a plurality of second through holes extending through the third support layer and the fourth support layer, wherein the plurality of second through holes extend through the plurality of second sound holes respectively;
filling the plurality of second through holes to form a plurality of second pillars;
forming a fourth vibrating diaphragm layer on the fourth support layer, and patterning the fourth vibrating diaphragm layer to form the fourth vibrating diaphragm, wherein a plurality of diaphragm holes are formed in the fourth vibrating diaphragm; and
etching the third support layer and the fourth support layer to form the second cavity between the third vibrating diaphragm and the fourth vibrating diaphragm, wherein a remaining portion of the third support layer forms a third support portion, and a remaining portion of the fourth support layer forms a fourth support portion.

12. The method according to claim 10, wherein after directly bonding the second vibrating diaphragm and the fourth vibrating diaphragm to form the common vibrating diaphragm further, the method further comprises:
removing the second substrate to expose the third vibrating diaphragm; and
etching the first substrate to expose a region on the first vibrating diaphragm corresponding to the first cavity.
